# EUROPEAN PATENT SPECIFICATION

(11) **EP 0 401 440 B1**
(45) Date of publication and mention of the grant of the patent: **15.09.1999**
(21) Application number: 89305819.8
(22) Date of filing: 09.06.1989
(51) Int. Cl.: H01L 27/06, B41J 2/05

(54) **Monolithic silicon integrated circuit chip for a thermal ink jet printer**
Monolithisch integrierte Siliciumschaltkreis für einen Thermotintenstrahldrucker
Puce de circuit intégré monolithique en silicium pour une imprimante thermique à jet d'encre

(43) Date of publication of application: 12.12.1990
(73) Proprietor: XEROX CORPORATION, Rochester, New York 14644 (US)
(72) Inventor: Hawkins, William G., Webster New York 14580 (US); Burke, Cathie J., Brighton New York 14625 (US)
(74) Representative: Walker, Antony James Alexander

(56) References cited:
- EP-A- 0 229 673
- EP-A- 0 287 195
- US-A- 4 246 593
- US-A- 4 532 530
- PATENT ABSTRACTS OF JAPAN, vol 9, no 85, (E-308)[1808], April 13, 1985, Tokyo, Japan & JP-A-59 217 353 (SEIKO DENSHI KOGYO K.K.)

## Description

This invention relates to bubble ink jet printing systems and, more particularly, to an integrated circuit chip which contains active driver, logic and resistive heater elements.

Thermal ink jet printers are well known in the prior art as exemplified by US-A-4,463,359 and 4,601,777. In the systems disclosed in these patents, a thermal printhead comprises one or more ink filled channels communicating with a relatively small ink supply chamber at one end and having an opening at the opposite end, referred to as a nozzle. A plurality of thermal energy generators, usually resistors, are located in the channels at a predetermined distance from the nozzle. The resistors are individually addressed with a current pulse to momentarily vaporize the ink and form a bubble which expells an ink droplet. As the bubble grows, the ink bulges from the nozzle and is contained by the surface tension of the ink as a meniscus. As the bubble begins to collapse, the ink still in the channel between the nozzle and bubble starts to move towards the collapsing bubble, causing a volumetric contraction of the ink at the nozzle and resulting in the separating of the bulging ink as a droplet. The acceleration of the ink out of the nozzle while the bubble is growing provides the momentum and velocity of the droplet in a substantially straight line direction towards a recording medium, such as paper.

In order to generate the resistor current pulses, some type of active drive device must be employed. Preferably, the drive circuitry should be formed on the same chip as the resistive elements. Prior art printheads use transistors having both positive and negative charge carriers (bipolar circuitry). Examples of printheads using bipolar drive circuits combined on the same chip as the resistors are provided in US-A-4,251,824, 4,410,899 and 4,412,224. The disadvantages of the bipolar drive circuit prior art devices is that they require an expensive manufacturing technique and that they provide an inefficient use of the thermal energy. If the printhead could be made more thermally efficient, then less expensive MOS type circuitry (N-MOS) can be used to drive the head instead of the more expensive bipolar circuitry. Additionally, bipolar transistors exhibit destructive thermal run away when switching high currents. It is, of course, desirable and cost effective to have a resistor structure which is immediately and simply integrated on the same wafer with MOS drive electronics, preferably without additional process steps.

Prior art devices which utilize MOS type circuitry are disclosed in US-A-4,595,821 and 4,532,530.

In US-A-4 595 821, a thermal printhead is disclosed in which a CMOS control circuit is mounted on a ceramic substrate upon which is also mounted the resistor element. This configuration is not suitable for thermal ink jet printing applications. In US-A-4 532 530, a thermal printhead is formed, as the Figure 4A and 4B embodiments. A polycrystalline silicon is simultaneously used to form the resistor and the associated drive circuitry. This configuration requires that each resistor element be attached to a bonding pad by a separate utilization contact process. Factors such as cost, more limited reliability and ink jet chip parameter space required for a bonding pad associated with every resistor, are disadvantages for moderate and high speed printing applications and for printing at a density near or above 120 spots per cm.

It is an object of the present invention to provide a monolithic silicon semiconductor integrated chip incorporating both MOS transistor drivers and resistive heater elements which is more reliable in operation and more compact than prior art devices.

According to the present invention there is provided a monolithic silicon integrated circuit chip as defined in claim 1.

An integrated circuit chip in accordance with the invention will now be described, by way of example, with reference to the accompanying drawings, in which:-

Figure **1** is a schematic perspective view of a carriage type bubble jet ink printing system incorporating the present invention.

Figure **2** is an enlarged schematic perspective view of the bubble jet ink printing head of Figure 1.

Figure **3** is an enlarged, cross-sectional view of a first embodiment of the integrated circuit chip of the present invention.

Figure **4** is an enlarged, cross-sectional view of a prior art silicon logic integrated circuit.

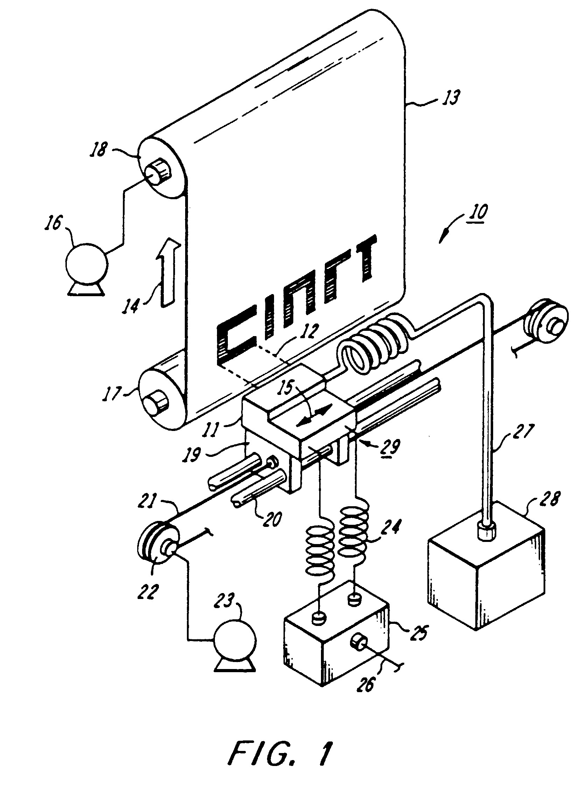

The printers which make use of thermal ink jet transducers can contain either stationary paper and a moving print head or a stationary pagewidth printhead with moving paper. A carriage type bubble jet ink printing device **10** is shown in Figure **1**. A linear array of droplet producing bubble jet channels is housed in the printing head **11** of reciprocating carriage assembly **29**. Droplets **12** are propelled to the recording medium **13** which is stepped by stepper motor **16** a preselected distance in the direction of arrow **14** each time the printing head traverses in one direction across the recording medium in the direction of arrow **15**. The recording medium, such as paper, is stored on supply roll **17** and stepped onto roll **18** by stepper motor **16** by means well known in the art.

The printing head **11** is fixedly mounted on support base **19** which is adapted for reciprocal movement by any well known means such as by two parallel guide rails **20**. The printing head base comprises the reciprocating carriage assembly **29** which is moved back and forth across the recording medium in a direction parallel thereto and perpendicular to the direction in which the recording medium is stepped. The reciprocal movement of the head is achieved by a cable **21** and a pair of rotatable pulleys **22**, one of which is powered by a reversible motor **23**.

The current pulses are applied to the individual bubble generating resistors in each ink channel forming the array housed in the printing head **11** by connections **24** from a controller **25**. The current pulses which produce the ink droplets are generated in response to digital data signals received by the controller through electrode **26**. The ink channels are maintained full during operation via hose **27** from ink supply **28**.

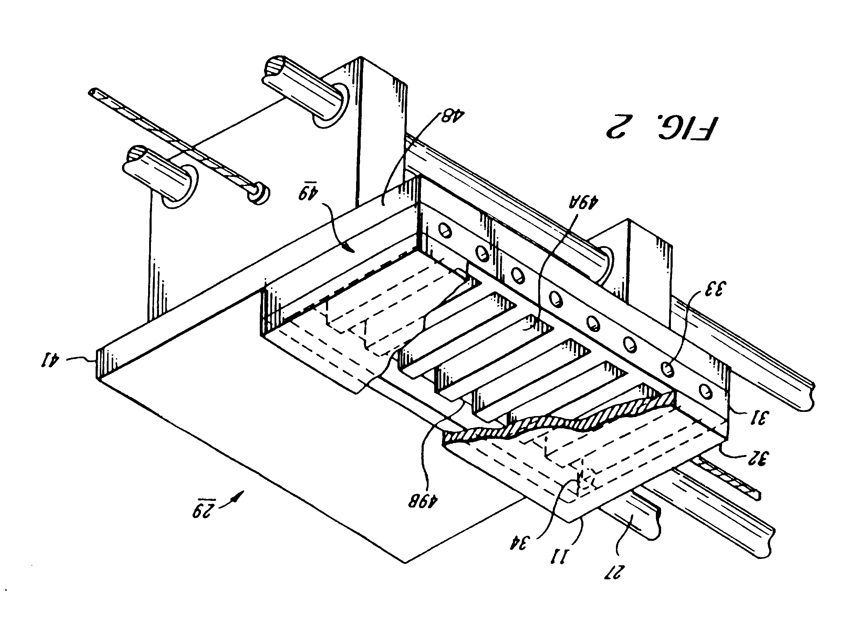

Figure **2** is an enlarged, partially sectioned, perspective schematic of the carriage assembly **29** shown in Figure **1**. The printing head **11** is shown in three parts. One part is the substrate **41** containing the electrical leads and monolithic silicon semi-conductor integrated circuit chip **48**. The next two parts comprise the channel plate **49** having ink channels **49*a*** and manifold **49*b***. Although the channel plate **49** is shown in two separate pieces **31** and **32**, the channel plate could be an integral structure. The ink channels **49*a*** and ink manifold **49*b*** are formed in the channel plate piece **31** having nozzles **33** at the end of each ink channel opposite the end connecting the manifold **49*b***. The ink supply hose **27** is connected to the manifold **49*b*** via a passageway **34** in channel plate piece **31** shown in dashed line. Channel plate piece **32** is a flat member to cover channel **49*a*** and ink manifold **49*b*** as they are appropriately aligned and fixedly mounted on the silicon substrate **41**.

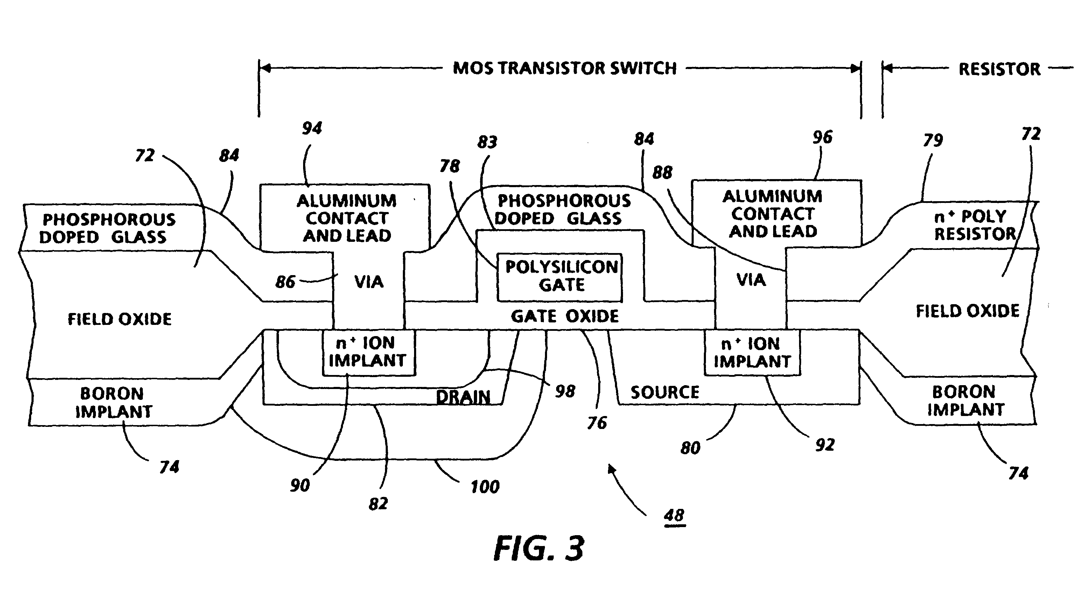

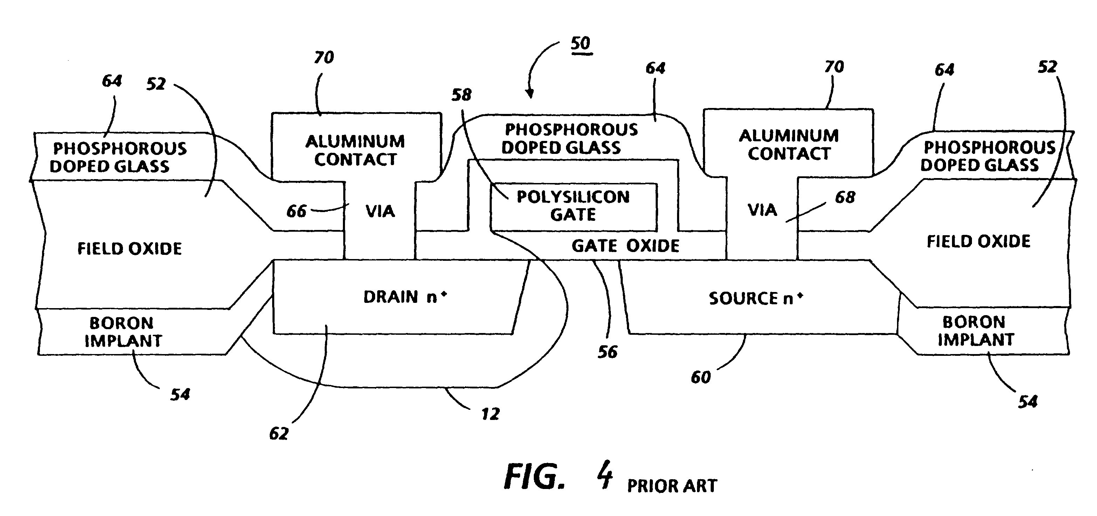

The integrated circuit chip **48**, shown in the embodiment in Figure **3** is formed, to some extent, according to standard NMOS process steps but modified in certain important respects. These modifications, discussed in full detail below, yield a compact and low cost circuit chip with increased thermal efficiency, and with higher breakdown voltages than prior art devices. In order to appreciate the process modification, a standard NMOS logic processing procedure used to fabricate silicon logic integrated circuits is reviewed in connection with fabrication of a prior art semiconductor transistor circuit shown in Figure **4**. Device **50**, shown in cross-section, is formed by processing a p type silicon substrate wafer by the LOCOS (local oxidation of silicon) process to form a thin SiO₂ layer followed by deposition of a silicon nitride masking layer. A first photoresist layer is applied and patterned over the areas which will form the active enhancement and depletion mode device areas. The resist is first used to pattern the Si₃N₄ layer and then to block a channel stop boron implant from the active device areas. A channel stop boron implant **54** is aligned to the field oxide areas. The photoresist is then removed and the wafers are cleaned in a series of chemical solutions, and heated to a temperature of about 1000°C. Steam is flowed past the wafer to oxidize the surface for several hours. Silicon surfaces with Si₃N₄ present are not oxidized. The Si₃N₄ and pad SiO₂ are then removed to leave bare silicon in active areas and a thick isolation oxide (field oxide layers **52**) elsewhere. The active devices are then selected to be depletion mode (normally on) or enhancement mode (normally off) by a second layer of patterned photoresist and ion implantation of an n-type silicon dopant. The resist is stripped and the wafer is cleaned and heated until a thin (≤ 150 nm) gate oxide layer **56** is grown, typically in dry O_{2,} but optionally in steam. A boron threshold adjustment implant through the gate oxide then sets the threshold voltage of the enhancement mode devices. A polysilicon layer **58** is deposited, doped and patterned to form the device gate and provide additional interconnection. Resist is removed and heavily doped n⁺ source and drain regions **60** and **62**, respectively, are formed adjacent to the gate layer **56** by ion implantation or diffusion. Following a cleaning procedure, the polysilicon and source-drain regions are re-oxidized and a phosphorous doped reflow glass is deposited and flowed at high temperature to planarize the surface topography to form layers **64**. A fourth level of photoresist is then applied, patterned and etched to create vias **66** and **68** which allow contact to be made to the gate layer **56** and source and drain regions **60** and **62**. Following a cleaning procedure, aluminum metalization is applied and patterned with a fifth layer of photoresist to form interconnections **70** to the drain and source as well as interconnecting various devices on the chip. An SiO₂ or Si₃N₄ low temperature layer is then applied and patterned to allow electrical interconnection of the chip. When a bias is applied to the drain of this device, a region around the drain area becomes depleted of carriers. As the bias continues to increase, breakdown will occur at the junction of the gate and the drain because of the high fields existing in the area.

Figure **3** shows an active address chip **48** having an MOS transistor switch monolithically integrated on the same substrate with the resistor. The chip is constructed by modifying techniques used to make the structure of Figure **5**, the modifications resulting in improved performance as will be seen. Considering Figure **3**, after the boron channel stop implant **74** is set, the field oxide layer **72** is grown at high temperature. According to the invention, the layer is about 1 to 4 micrometers thick. Gate oxide layer **76** is grown in the power areas and a single polysilicon layer is deposited to form the transistor gates **78** and resistors **79**. The polysilicon layer produces a sheet resistance between 5Ω/□ and 5 kΩ/□. The polysilicon gates are used to mask ion implantation from the active transistor device channel area while a lightly doped source **80** and drain **82** implant is formed to produce a sheet resistance of between 500 Ω/□ and 20 kΩ/□ but, preferably, about 4 kΩ/□. The wafer is then cleaned and re-oxidized to form oxidized layer **83**. A phosphorus doped glass layer **84** is then deposited on the thermal oxide layer **83** and is flowed at high temperatures in order to planarize the surface. Photoresist is applied and patterned to form vias **86** and **88** to drain **82** and source **80**, respectively. According to the invention, the contact areas are heavily doped by n⁺ ion implants **90**, **92** to allow ohmic contact between the lightly doped drain and source layers **82**, **80** and aluminum metallization **94**, **96**. Following the thermal cycle necessary to activate the heavily doped regions **90**, **92**, the wafers are cleaned and aluminum metallization is applied to form interconnections **94**, **96** thus providing contacts to the source, drain and polysilicon gate regions. In operation, as a bias is applied to the drain **82**, the region around gate **78** becomes depleted of carriers into drain area **82**, so that the edge of the depleted region looks similar to the boundaries outlined by lines **98**, **100**. Because the drain area becomes depleted, the electric field at the junction of gate **78** and drain implant **90** is less severe, so a high voltage can be tolerated before breakdown. By self-aligning the n-drift layer **82** to the polysilicon gate **78**, breakdown voltage can be extended up to values greater than 75 volts, compared to a breakdown voltage of approximately 20 volts in the prior art device shown in Figure **5**. As shown in the following table, there is an inverse correlation between driver breakdown voltage and chip size. Chip size increases from 2.0 to 3.5 mm as the operating voltage decreases from 60 volts to 15 volts. As the size of an integrated circuit increases, manufacturing cost rises rapidly both because greater area of material is consumed and yield falls as size grows as well. Decreasing chip size from 3.5 mm to 2.0 mm by increasing breakdown voltage from 15 to 60 volts, at least halves the chip cost.

**TABLE**

| **Voltage** | **Transistor** | **Length** | **Chip Size** | **Resistor** |
|---|---|---|---|---|
| 15 | 84 x 2000 µm | 2.0 mm | 3.5 mm | 64 Ω |
| 30 | 84 x 1000 µm | 1.0 mm | 2.5 mm | 90 Ω |
| 45 | 84 x 750 µm | 0.75 mm | 2.2 mm | 127 Ω |
| 60 | 84 x 500 µm | 0.5 mm | 2.0 mm | 360 Ω |

As described above, field oxide layer **72** is grown so as to exceed a 1 µm thickness. In the standard NMOS process flow described above, field oxide regions ≤ 1.0 µm thick were grown on the surface of the silicon wafer in areas where transistors will not be formed. This thickness was sufficient to electrically isolate the individual transistors. In a thermal ink jet printing environment, a primary consideration is maintaining a thermally efficient heat dissipation from the resistor area. The resistors are typically heated by 2 µsec to 10 µsec electrical heating pulses The energy required to eject an ink droplet suitable for a 120 spots per cm printing system is 15 µjoules to 50 µjoules depending on the resistor design efficiency. With the resistor placed on top of the field oxide region, a thermally efficient resistor design will be one that provides low heat conduction from the resistor to the thermally conductive silicon substrate, thus reducing operating power requirements. It has been determined that a thermally efficient system is enabled by forming the oxide layer to a thickness of between 1-4 µm. For example, for 3 µsec heating pulses, the heat dissipation caused by heat flow from the resistor through the field oxide to the silicon substrate reaches a minimum where the field oxide layer is at least 2.0 µm thick. The upper level of the preferred oxide layer thickness range is limited by the field oxide and dopant encroachment into the active device area, the encroachment increasing superlinearly with oxide thickness. It has been determined experimentally that 5 µm wide enhancement mode NMOS devices have a ± 5% or 100 mV device threshold shift compared to a 10 µm wide device. Therefore, it is easily possible to build a 5 µm gate NMOS logic with a 2.0 µm thick field oxide. Numerical calculations show that 3 µsec heating pulse thermal efficiency differences between 1.0 µm and 2.0 µm of thermal oxide is 21%, while a difference of 37% is found for 5 µsec pulses. Therefore, the oxide thickness of the thermal oxide must be adjusted to give optimum thermal efficiency for a selected pulse length.

Turning next to the invention discussed above in connection with the deposition of a composite layer over the resistors, it has been found that polysilicon resistors are damaged by bubble collapse caused by heating of the ink over the resistors. These devices fail after 10⁶ cycles which corresponds to less than 1000 pages of printing. Covering the resistors with a layer extends the operating life to 10⁸ cycles.

The embodiment which has just been discussed demonstrates that drivers can be simultaneously fabricated with the resistive transducer elements. The presence of drivers alone allows reduction of interconnection from N connections to ≈ 2 N connections. For example, 50 jets can be addressed by ≈ 15 connections, and 200 jets can be addressed by ≈ 30 connections. Addition of logic circuitry allows for a further reduction in interconnection which becomes important for large arrays. It is possible to address an arbitrarily large number of jets with six or seven electrical connections. NMOS logic circuits can be added by including depletion mode photoresist masking and implant process steps in the fabrication sequence so that normally on and normally off devices are available to form logic gates. The polysilicon which is used to form the resistor elements and gates of drivers is simultaneously used to form the gates of the logic circuit elements.

While it is preferable to fabricate the logic gates with NMOS technology because of its simplicity and low cost, the use of CMOS logic technology is also a similar approach which could be used to form such circuits in a monolithic fashion. Also, while the active devices have been formed on a field oxide layer, an insulating substrate such as sapphire may be applicable for some systems.

## Claims

1. A monolithic silicon integrated circuit chip (48) for a thermal ink jet printhead, said chip comprising:
a plurality of MOS polysilicon gated transistor switches electrically connected to a plurality of polysilicon resistive bubble generating elements (79),
said resistive elements (79) being formed on a first region of a field oxide layer (72), which resides above a channel stop region (74) and which has a thickness ranging from about 1 to 4 micrometers, and with a sheet resistance of between 5 ohms/square and 5K ohms/square,
at least one of the transistor switches having a polysilicon gate (78), a source (80), and a second region of the field oxide layer (72), and a heavily doped n⁺ drain region (90) located between the second region of the field oxide layer (72) and the polysilicon gate, the heavily doped n⁺ drain region being laterally separated from the polysilicon gate (78) and from the second region of the field oxide layer (72),
the transistor further comprises a lightly doped n- drift region (82) which is at least situated between the heavily doped n⁺ region (90) and the polysilicon gate (78) and between the heavily doped n⁺ drain region and the second region of the field oxide layer (72),
at least one source via (88) connecting the transistor to an associated resistive element (79),
wherein the voltage applied to at least the heavily doped n⁺ drain (90) of the transistor switch produces a depletion region (98, 100) which extends laterally towards the polysilicon gate (78) thereby producing a reduced electric field at the gate drain junction that increases device breakdown voltage.

2. The monolithic silicon integrated circuit chip of claim 1, wherein a single layer of polysilicon is used for the gate (78) of the transistor switch and for the resistive element (79).

3. The monolithic silicon integrated circuit chip of claims 1 or 2, wherein the chip is formed from a p type silicon wafer.

4. A thermal ink jet printhead including the monolithic silicon integrated circuit chip of any one of claims 1 to 3.

## Patentansprüche

1. Integrierter, monolithischer Silizium-Schaltkreis-Chip (48) für einen thermischen Tintenstrahldruckkopf, wobei der Chip aufweist:
eine Vielzahl von torgesteuerten MOS-Transistor-Schaltern, die elektrisch mit einer Vielzahl von Polysilizium-Widerstandsblasen-Erzeugungselementen (79) verbunden sind,
wobei die Widerstandselemente (79) auf einem ersten Bereich einer Feldoxidschicht (72) gebildet sind, die oberhalb eines Kanal-Stop-Bereichs (74) vorhanden ist und die eine Dicke besitzt, die von ungefähr 1 bis 4 Mikrometern reicht, und mit einem Schichtwiderstand zwischen 5 Ohm/Quadrat und 5K Ohm/Quadrat,
wobei mindestens einer der Transistor-Schalter ein Polysilizium-Gate (78), eine Source (80) und einen zweiten Bereich der Feldoxidschicht (72) besitzt, und einen stark dotierten n⁺-Drain-Bereich (90), der zwischen dem zweiten Bereich der Feldoxidschicht (72) und dem Polysilizium-Gate angeordnet ist, wobei der stark dotierte n⁺-Drain-Bereich lateral von dem Polysilizium-Gate (78) und von dem zweiten Bereich der Feldoxidschicht (72) separiert ist,
wobei der Transistor weiterhin einen leicht dotierten n⁻-Drift-Bereich (82) aufweist, der zumindest zwischen dem stark dotierten n⁺-Bereich (90) und dem Polysilizium-Gate (78) und zwischen dem stark dotierten n⁺-Drain-Bereich und dem zweiten Bereich der Feldoxidschicht (72) angeordnet ist,
wobei mindestens ein Source-Durchgangsloch (88) den Transistor mit einem zugeordneten Widerstandselement (79) verbindet,
wobei die Spannung, die an zumindest das stark dotierte n⁺-Drain (90) des Transistorschalters angelegt ist, einen Verarmungsbereich (98, 100) produziert, der sich lateral zu dem Polysilizium-Gate (78) erstreckt, um dadurch ein reduziertes, elektrisches Feld an der Gate-Drain-Übergang zu produzieren, die die Vorrichtungsdurchschlagsspannung erhöht.

2. Monolithischer, integrierter Silizium-Schaltkreis-Chip nach Anspruch 1, wobei eine einzelne Schicht aus Polysilizium für das Gate (78) des Transistor-Schalters und für das Widerstandselement (79) verwendet wird.

3. Monolithischer, integrierter Silizium-Schaltkreis-Chip nach Anspruch 1 oder 2, wobei der Chip aus einem Silizium-Wafer vom p-Typ gebildet ist.

4. Thermischer Tintenstrahldruckkopf, der den monolithischen, integrierten Silizium-Schaltkreis-Chip irgendeines der Ansprüche 1 bis 3 umfaßt.

## Revendications

1. Puce (48) de circuit intégré en silicium monolithique pour une tête d'impression à jet d'encre thermique, ladite puce comprenant :
une pluralité de commutateurs à transistors en polysilicium de type MOS commandés par porte, électriquement connectés à une pluralité d'éléments (79) résistifs générateurs de bulles en polysilicium,
lesdits éléments (79) résistifs étant formés sur une première région d'une couche (72) d'oxyde épais qui est placée au-dessus d'une région (74) d'arrêt de canal et qui a une épaisseur dans la gamme d'environ 1 à 4 micromètres, et ayant une résistance par carré comprise entre 5 ohms/carré et 5 kohms/carré,
au moins l'un des commutateurs à transistors ayant une grille (78) de polysilicium, une source (80), et une seconde région de la couche (72) d'oxyde épais, et une région (90) de drain de type n+ fortement dopée située entre la seconde région de la couche (72) d'oxyde épais et la grille de polysilicium, la région de drain de type n+ fortement dopée étant séparée latéralement de la grille (78) de polysilicium et de la seconde région de la couche (72) d'oxyde épais,
le transistor comprend en outre une région (82) de dérive de type n- légèrement dopée qui est au moins située entre la région (90) de type n+ fortement dopée et la grille (78) de polysilicium et entre la région de drain de type n+ fortement dopée et la seconde région de la couche (72) d'oxyde épais,
au moins un trou traversant (88) de source connectant le transistor à un élément (79) résistif associé,
dans lequel la tension appliquée à au moins le drain (90) de type n+ fortement dopé du commutateur à transistor produit une région (98, 100) d'appauvrissement qui s'étend latéralement vers la grille (78) de polysilicium en produisant ainsi un champ électrique au niveau de la jonction grille-drain qui fait croître la tension de claquage du dispositif.

2. Puce de circuit intégré en silicium monolithique selon la revendication 1, dans laquelle une couche unique de polysilicium est utilisée pour la grille (78) du commutateur à transistor et pour l'élément (79) résistif.

3. Puce de circuit intégré en silicium monolithique selon les revendications 1 ou 2, dans laquelle la puce est formée d'une plaque de silicium de type p.

4. Tête d'impression à jet d'encre thermique comportant une puce de circuit intégré en silicium monolithique selon l'une quelconque des revendications 1 à 3.
